(19) Europäisches Patentamt
European Patent Office
Office européen des brevets

(11) **EP 2 215 490 B1**

(12) **EUROPÄISCHE PATENTSCHRIFT**

(45) Veröffentlichungstag und Bekanntmachung des Hinweises auf die Patenterteilung:
**11.01.2017 Patentblatt 2017/02**

(21) Anmeldenummer: **08856825.8**

(22) Anmeldetag: **18.11.2008**

(51) Int Cl.:
**G01R 31/34** $^{(2006.01)}$

(86) Internationale Anmeldenummer:
**PCT/EP2008/065714**

(87) Internationale Veröffentlichungsnummer:
**WO 2009/071438 (11.06.2009 Gazette 2009/24)**

(54) **VERFAHREN ZUR DETEKTION VON INTERLAMINAREN BLECHSCHLÜSSEN IM STATOR-BLECHPAKET VON ELEKTROMASCHINEN**

METHOD FOR DETECTION OF INTERLAMINAR SHEET SHORT CIRCUITS IN THE STATOR SHEET CORE OF ELECTROMACHINES

PROCÉDÉ DE DÉTECTION DE COURTS-CIRCUITS ENTRE LES TÔLES DANS LE NOYAU MAGNÉTIQUE DU STATOR DE MACHINES ÉLECTRIQUES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **07.12.2007 CH 18942007**

(43) Veröffentlichungstag der Anmeldung:
**11.08.2010 Patentblatt 2010/32**

(73) Patentinhaber: **General Electric Technology GmbH**
**5400 Baden (CH)**

(72) Erfinder: **HOBELSBERGER, Max**
**CH-5303 Würenlingen (CH)**

(74) Vertreter: **General Electric Technology GmbH**
**GE Corporate Intellectual Property**
**Brown Boveri Strasse 7**
**5400 Baden (CH)**

(56) Entgegenhaltungen:
**EP-A- 1 318 411    WO-A-02/10737**
**AT-B- 390 522    US-A1- 2004 000 923**

**Beschreibung**

**Technisches Gebiet**

Die vorliegende Erfindung betrifft ein Verfahren zur Detektion von interlaminaren Blechschlüssen im Stator-Blechpaket von Elektromaschinen, insbesondere von grossen Generatoren. Insbesondere geht es um die Verbesserung einer Vorrichtung und eines Verfahrens, bei welchem das Stator-Blechpaket einem von aussen angelegten Erregungsstrom respektive Erregungsspannung ausgesetzt wird und unter Zuhilfenahme einer im Spalt der Maschine angeordneten und diesen Spalt abtastende Sensorspule das durch Kurzschlussströme induzierte Kurzschluss-Magnetfeld ausgemessen wird.

**Stand der Technik**

Grosse Generatoren und Motoren werden routinemässig im Stillstand auf Blechschlüsse hin untersucht. Dazu stehen verschiedene Methoden zur Verfügung.

Eine dieser Methoden umfasst die Magnetisierung des ganzen Blechkörpers mittels einer Hilfsspule bei Netzfrequenz und die Messung von Streufeldern auf der inneren Oberfläche der Statorbohrung. Die Magnetisierung erfolgt auf relativ niedrige Werte der magnetischen Induktion, typischerweise auf etwa 10% der normalen Betriebsinduktion. Diese Messmethode ist auch unter dem Namen "Niederinduktions- Blechschlussmessung" bekannt, im englischen Sprachraum unter dem Namen "ELCID" (Electromagnetic Core Imperfection Detector).

Ein Verfahren dieser Art ist beispielsweise beschrieben in der US 4996486. Stand der Technik ist es also, das Stator-Blechpaket mittels einer Hilfsspule und einer daran angelegten sinusförmigen Hilfsspannung mit Netzfrequenz auf etwa ein Zehntel der Betriebsinduktion zu magnetisieren. Diese Hilfsspannung ist üblicherweise direkt aus der Netzspannung abgeleitet. Mit einer elektrischen Aufnahmespule wird dann die Oberfläche der Stator - Bohrung abgefahren, wobei sich die Aufnahmespule nahe der Oberfläche des Blechpakets befindet.

Die Ströme, die aufgrund der interlaminaren Kurzschlüsse des Blechpakets fliessen, induzieren nun in der Aufnahmespule Spannungen mit charakteristischer Phasenlage und Amplitudengrösse. Aufgrund der charakteristischen Phasen- und Amplitudenlage können Orte mit Blechschluss-Strömen von Orten ohne Blechschluss - Strömen unterschieden werden. Es ist somit möglich, mittels dieses Streufeldes - Aufnahmespule Blechschlüsse zu lokalisieren und die Grösse der Kurzschlussströme zu beurteilen.

WO 02/10737 A2 beschreibt ein Verfahren sowie ein System zur Detektion von Statorkernfehlern.

In der Patentschrift US 6,903,556 wird des Weiteren ein System vorgestellt, das mit Magnetisierungsspannungen mit höherer Frequenz als Netzfrequenz arbeitet. Nachteilig bei den genannten Verfahren ist, dass die Interpretation der Messergebnisse oft schwierig ist, da die von den Blechschlussströmen induzierten Spannungen meist sehr klein sind. Insbesondere können starke Streufelder des Stator-Hauptfeldes oder auch verlustbehaftete Zusatzfelder, die z.B. durch in kurzgeschlossenen Leiterschleifen induzierte Ströme zustande kommen, die Wirkung des eigentlichen Kurzschlussstromes durch die Fehlerstelle überdecken und so eine Detektion erschweren.

Dies ist besonders bei kleinen Blech - Fehlern der Fall, die nur kleine Ströme führen und nur eine kleine magnetische Wirkung haben. Störende Zusatzfelder treten besonders bei der Prüfung von Hydrogeneratoren auf, wenn zur Prüfung der Rotor nicht entfernt wurde, sodass die Einzelpole eine magnetische Wirkung ausüben.

Gemäss US 6,903,556 kann die Zuverlässigkeit der Messung erhöht werden, indem der Stator mit höherer Frequenz magnetisiert wird. Dazu wird an die Magnetisierungsspule eine sinusförmige Wechselspannung höherer Frequenz angelegt. Gemäss der "ELCID" Messmethode werden dann die sogenannten "magnetischen Potentialunterschiede" (MPD) ermittelt. Diese sind den jeweiligen das Feld durch die Messspule beeinflussenden elektrischen Strömen proportional. Da bei höherer Frequenz nur ein kleinerer Magnetisierungsstrom notwendig ist, um den gleichen Kurzschlussstrom durch die Fehlerstelle zu bewirken als bei Magnetisierung mit niedrigerer Frequenz, ist die entsprechende MPD-Komponente des Kurzschlussstromes in Relation zur entsprechenden Komponente des Erregungsstromes grösser als bei niedrigerer Frequenz, d.h. die Messung wird genauer und sensitiver. Nachteilig ist bei dieser Messmethode der notwendige Zusatzaufwand für den Hochfrequenz - Generator für den Erregerstrom. Des Weiteren ist nachteilig, dass mit genau eingestellten und bekannten bzw. gemessenen Werten der Statorinduktion gearbeitet werden muss, da die Messergebnisse mit Absolut-Grenzwerten verglichen werden und danach beurteilt werden.

**Darstellung der Erfindung**

Die vorliegende Erfindung bezieht sich auf eine Verbesserung der Niederinduktions - Messmethode. Der Erfindung liegt demnach u.a. der Gegenstand zugrunde, ein verbessertes Verfahren respektive auch eine zusätzliche Vorrichtung zur Detektion von interlaminaren Blechschlüssen im Stator-Blechpaket von Elektromaschinen zur Verfügung zu stellen. Spezifisch geht es dabei um die Verbesserung eines Verfahrens, bei welchem das Stator-Blechpaket einem von aussen angelegten Erregungsstrom respektive Erregungsspannung ausgesetzt wird und unter Zuhilfenahme einer im Spalt der Maschine angeordneten und diesen Spalt abtastende Sensorspule das durch Kurzschlussströme induzierte Kurzschluss-Magnetfeld ausgemessen wird.

Die Verbesserung dieses Verfahrens wird dadurch erreicht, dass ein Erregungsstrom respektive eine Erregungsspannung verwendet werden, welche einen wesentlich von einer Sinusform abweichenden zeitlichen Verlauf aufweisen. Unter Sinusform ist dabei eine Form zu verstehen, die im wesentlichen nur aus einem Sinus bei einer Grund-Frequenz aufgebaut ist. Eine Überlagerung von zwei Sinus-Formen mit je unterschiedlicher Frequenz (eine Grundfrequenz und eine Harmonische) ist also z.B. ein wesentlich von einer Sinusform abweichender zeitlicher Verlauf.

Grundlage des neuen Verfahrens ist u.a. die Erkenntnis, dass ein nicht-sinusförmiges resp. nicht-cosinusförmiges Einganssignal mathematisch als eine Summe von sinusförmigen Signalkomponenten dargestellt werden kann (Fourierreihe). Diese weiteren Signalkomponenten, die bei periodischen Signalen bei mehrfachen der Grundfrequenz angeordnet sind, werden als Harmonische, Einzelharmonische oder Obertöne bezeichnet.

Eine weitere Grundlage des neuen Verfahrens ist unter anderem die Erkenntnis, dass nach der Systemtheorie ein lineares System so auf ein Eingangssignal reagiert, dass sein Ausgangssignal wiederum in genau diese harmonischen Einzelkomponenten aufgeteilt werden kann, wobei eine definierte Transferfunktion (Übertragungsfunktion) existiert. Diese Funktion beschreibt die Phasen- und Amplitudenrelationen zwischen Eingangsharmonischen und zugehörigen Ausgangsharmonischen, wobei sich die einzelnen Harmonischen in der linearen Näherung nicht gegenseitig beeinflussen.

Grundlage ist des Weiteren die Erkenntnis, dass bis zu einer gewissen Grenzfrequenz der elektrische Kreis des Blechkurzschlusses primär resistiv ist. Das bedeutet, dass der Kurzschlussstrom in diesem Kreis mit guter Näherung nur von der Erregungsspannung abhängt, jedoch nur wenig von der Erregungsfrequenz beeinflusst wird. Dieser Sachverhalt gilt auch für die Einzelharmonischen des Erregungssignals. Der Erregungsstrom selbst nimmt jedoch bei steigender Frequenz annähernd linear ab. Diese Zusammenhänge werden zur Identifizierung von Blechkurzschlüssen verwendet.

Ausserdem ist eine weitere Grundlage die Erkenntnis, dass ein Generator aufgrund seiner Blechung bis zu mittleren Frequenzen von ca. 2 kHz noch relativ verlustarm, d.h. als guter Transformator, arbeitet. Die bedeutet einerseits, dass sich der Erregungsstrom bis zu höheren Frequenzen, d.h. höheren Harmonischen, i.w. linear verkleinert, andererseits die "Nutzspannung", das ist die vom Blechschlussstrom in der Messsonde induzierte Spannung, mit der Frequenz linear steigt. Die 5. Harmonische benötigt somit z.B. nur 1/25 des Stromes der Grundharmonischen, um die gleiche Nutzspannung zu erzeugen. Kern der Erfindung ist also mit anderen Worten die unerwartete Erkenntnis, dass die Verwendung von Erregungsstrom respektive Erregungsspannung mit einem Kurvenverlauf, der wesentliche harmonische Komponenten aufweist, d.h. nichtsinusförmig ist, besonders gut für das vorgeschlagene Verfahren verwendet werden kann. Die höheren harmonischen Komponenten werden dabei, obwohl sie im Spektrum der Erregung für zunehmende Frequenz eine abnehmende Amplitude aufweisen, für die Messung von Blechschlüssen wegen des gegenläufigen Verhaltens der in der Messsonde induzierten Spannung, optimal zur Identifikation von Blechschlüssen verwendet werden, ohne dass die hohen Frequenzen ausdrücklich mit einem spezifischen Frequenzgenerator erzeugt werden müssen.

Eine erste bevorzugte Ausführungsform der Erfindung ist entsprechend dadurch gekennzeichnet, dass es sich beim zeitlichen Verlauf von Erregungsstrom respektive Erregungsspannung um einen periodischen Verlauf mit wesentlichen höheren Harmonischen handelt. Ein solcher periodischer Verlauf lässt sich als Fourierreihe entwickeln, das heisst das Signal der Erregung lässt sich zerlegen in eine lineare Kombination von sinusförmigen Komponenten mit Frequenzen bei den ganzzahligen Vielfachen (Harmonische) der Grundfrequenz des periodischen Signals. Grundsätzlich ist im Rahmen der vorliegenden Erfindung eine Form der Erregungsspannung respektive Erregungsstrom von Vorteil, welche wesentliche Komponenten, das heisst wesentliche Amplituden bei diesen Harmonischen aufweisen. Vorzugsweise sollten die Amplituden der zweiten bis zehnten Harmonischen grössenordnungsmässig im Bereich der Grundharmonischen liegen, z.B. im Bereich 10% - 300 %. Bevorzugt ist beispielsweise ein Signal, bei welchem die Amplitude der Harmonischen im wesentlichen mit zunehmender Frequenz linear, exponentiell oder quasi-linear abnehmend ist.

Vorzugsweise handelt es sich es sich beim zeitlichen Verlauf von Erregungsstrom respektive Erregungsspannung um eine Trapezfunktion, eine Sägezahnfunktion, eine Rechteckfunktion oder eine modifizierte Rechteckfunktion. Wie aus der Fourier-Theorie bekannt ist, verfügen insbesondere Funktionen, welche scharfe Kanten aufweisen, über wesentliche Obertöne. Eine bevorzugte Form ist entsprechend, wenn es sich beim zeitlichen Verlauf von Erregungsstrom respektive Erregungsspannung um eine symmetrische Rechteckfunktion mit gleich langen positiven und negativen Abschnitten handelt, bevorzugt ohne weitere, beispielsweise Null-Abschnitte.

Eine weitere bevorzugte Ausführungsform des Verfahrens ist dadurch gekennzeichnet, dass der zeitliche periodische Verlauf von Erregungsstrom respektive Erregungsspannung eine Grund-Frequenz im Bereich von 10-500 Hz, insbesondere bevorzugt im Bereich von 40-100 Hz aufweist. Typischerweise wird die Netzfrequenz von 50 Hz oder 60 Hz verwendet. Um Störungen in der Messung zu vermeiden, erweist es sich als vorteilhaft, wenn die Grund-Frequenz des periodischen Verlaufs mit der für die Erregung verwendeten Netzspannung synchronisiert ist.

Eine weitere Ausführungsform der Erfindung ist dadurch gekennzeichnet, dass Messung und Auswertung auf Basis der Phasenwinkel, definiert als Differenz zwischen Ausgangs-Phasenwinkel und Eingangs-Phasenwinkel der einzelnen Harmonischen von Erregungsstrom respektive Erregungsspannung, erfolgt. Es kann also vorzugsweise die (Veränderung der) Transferfunktion für jede Harmonische ausgewertet werden und zwar hinsichtlich Amplitude wie auch hinsichtlich Phase. Dabei kann der im wesentlichen lineare Zusammenhang zwischen Phasenwinkel und Frequenz zur Identifikation von Blechschlüssen verwendet werden.

Eine weitere bevorzugte Ausführungsform zeichnet sich dadurch aus, dass zur Identifikation von Blechschlüssen das in der Sensorspule aufgenommene Signal einer spektralen Analyse unter Zuhilfenahme einer Fourier-Transformation unterzogen wird. Dabei wird vorzugsweise das Phasenspektrum der unterschiedlichen Harmonischen zur Identifikation von Blechschlüssen verwendet.

Gemäss einer weiteren bevorzugte Ausführungsform findet zunächst vorgängig zur Messung oder danach eine Eichung der Messvorrichtung mittels einer an der Bohrungsoberfläche angeordneten Leiterschleife und eines durch diese Schleife fliessenden Eichstromes bekannter Grösse, der im wesentlichen die gleichen Harmonischen enthält, wie der zeitliche Verlauf von Erregungsstrom respektive Erregungsspannung wie während der eigentlichen Messung, wobei insbesondere bevorzugt zu Eichung der gleiche zeitliche Verlauf wie zur Messung verwendet wird.

Zur Identifikation von Blechschlüssen kann vorzugsweise eine kombinierte Strom-Spannungsanalyse durchgeführt werden, bevorzugt unter Berücksichtigung des insbesondere fallenden Phasenwinkels in Abhängigkeit steigender Frequenz. Oben wurde die Verwendung eines periodischen Verlaufs für Erregungsstrom respektive Erregungsspannung beschrieben. Es ist aber auch möglich, nichtperiodische Erregung vorzunehmen. So beispielsweise gemäss einer weiteren Ausführungsform, indem jeweils für eine Messung an einem bestimmten Ort im wesentlichen ein einziger Puls, insbesondere bevorzugt ein Rechteckpuls als Verlauf von Erregungsstrom respektive Erregungsspannung angelegt wird respektive eine Folge von unabhängig voneinander ausgewerteten und im Resultat gemittelten Pulsen.

Messung und Auswertung auf Blechschlüsse können also auf Basis der Phasenlagen und Amplitude in der einzelnen Harmonischen erfolgen. Die Phasenlagen und Amplituden der Harmonischen können zu diesem Zweck mittels Fourier-Analyse analysiert werden. Dabei ist es bevorzugt, so vorzugehen, dass eine örtlich simultane Änderung der Phasenwinkel mehrerer Harmonischer als Hinweis auf einen Blech-Kurzschluss gewertet wird.

Gleichermassen kann ein im wesentlichen linearer Zusammenhang zwischen Änderungen der Phasenwinkel und Frequenz der Harmonischen als Hinweis auf einen Blechschluss gewertet werden.

Die vorliegende Erfindung betrifft des Weiteren eine Vorrichtung zur Durchführung eines Verfahrens, gemäß Anspruch 17.

Eine solche Vorrichtung kann vorzugsweise dadurch gekennzeichnet sein, dass es sich beim Frequenz-Generator um eine elektronische Vollbrücke handelt. Zur Erregung kann vorzugsweise eine Erregungsspule, gegebenenfalls in Kombination mit einem Erregungsjoch, verwendet werden.

Weitere bevorzugte Ausführungsformen der Erfindung sind in den abhängigen Ansprüchen beschrieben.

**Kurze Erläuterung der Figuren**

Die Erfindung soll nachfolgend anhand von Ausführungsbeispielen im Zusammenhang mit den Zeichnungen näher erläutert werden. Es zeigen:

Fig. 1    einen Längsschnitt durch ein Stator-Blechpaket;
Fig. 2    einen Querschnitt durch ein Stator-Blechpaket;
Fig. 3    ein Vektordiagramm für Bedingungen bei unterschiedlichen Frequenzen;
Fig. 4    eine Vollbrücke zur Erzeugung der Erregungsspannung;
Fig. 5    unterschiedliche Pulsfolgeformen, wobei in a) eine periodische symmetrische Rechteckfunktion dargestellt ist, in b) eine modifizierte Rechteckfunktion und in c) eine Sägezahnfunktion;
Fig. 6    einen Querschnitt durch eine Situation mit lokaler Erregung, und
Fig. 7    einen Querschnitt durch eine Situation mit getrennter Anordnung von Mess- und Erregungsspule.

**Wege zur Ausführung der Erfindung**

Das neuartige Verfahren arbeitet, wie bereits eingangs erläutert, wiederum wie die üblichen ELCID-Verfahren, mit Niederinduktions-Erregung und einer Messspule zum Messen des Streufeldes. Es zeichnet nun aber insbesondere sich dadurch aus, dass der Stator mit nicht-sinusförmigen (respektive phasenverschoben cosinusförmigen) Signalverläufen der Erregungsspannung magnetisiert wird.

Typischerweise wird namentlich gemäss der Erfindung eine z.B. rechteckförmige, trapezförmige, Sägezahn-förmige oder allgemein pulsförmige Erregungsspannung verwendet. Die Periode p dieser Erregungsspannung kann der Periode der Netzspannung entsprechen, oder auch davon abweichen, z.B. kleiner sein. Es können auch nichtperiodische Spannungsformen, z.B. Einzelpulse, für die Erregung verwendet werden.

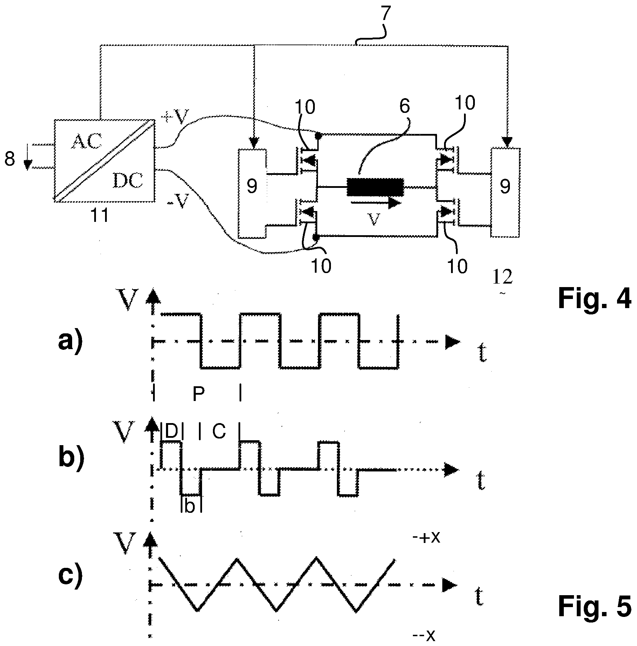

Generell ist dabei unter einer rechteckförmigen Erregungsspannung V (vergleiche auch Figur 5a) ein Verlauf zu verstehen, für welchen gilt:

$$V(t) = +x \qquad \text{für} \qquad 0 \leq t < p/2;$$

$$V(t) = -x \qquad \text{für} \qquad p/2 \leq t < p,$$

unter einer trapezförmigen oder dreieckförmigen Erregungsspannung V (vergleiche auch Figur 5c) zum Beispiel ein Verlauf, für welchen gilt:

$$V(t) = 4 \times t/p \qquad \text{für} \qquad 0 \leq t < p/4;$$

$$V(t) = 4 \times (1/2 - 1/p) \qquad \text{für} \qquad p/4 \leq t < 3/p/4;$$

$$V(t) = 4 \times (t/p - 3/4) \qquad \text{für} \qquad 3p/4 \leq t < p$$

(auch asymmetrische Aufteilungen etc. möglich);
und unter einer Sägezahn-förmigen Erregungsspannung V z.B. ein Verlauf, für welchen gilt:

$$V(t) = 2 \times (1/2 - 1/p) \qquad \text{für} \qquad 0 \leq t < p.$$

Auch verallgemeinerte Formen dieser Funktionen sind möglich, so beispielsweise eine Rechteckfunktion mit einem Null-Abschnitt c (vergleiche Figur 5 b).

Gleichermassen möglich sind Mischformen der oben angegebenen Verläufe respektive Formen, welche den oben angegebenen mathematisch formulierten Verläufen nur im wesentlichen entsprechen (gerundete Flanken etc. wegen der technischen Realisierung).

Diese nicht-sinusförmigen Spannungen V(t) lassen sich mit relativ einfachen Mitteln erzeugen, z.B. durch einfaches Umschalten zwischen einem positiven und einem negativen Spannungspegel. Dies ermöglicht den Aufbau von leichten, robusten und zuverlässigen Erregungseinrichtungen.

Des Weiteren zeichnet sich das neue Verfahren dadurch aus, dass sowohl die harmonische Grundwelle und als auch die harmonischen Oberwellen (Harmonische) des von der Messspule erzeugten Signals ausgewertet werden. Diese Auswertung erfolgt typischerweise in Form einer harmonischen Analyse sowohl des Messsignals und als auch des Erregungssignals. Phasen- und Amplitudeninformationen der einzelnen Harmonischen werden zur Detektion von laminaren Kurzschlüssen verwendet. Die harmonische Analyse bedient sich dabei der Mittel der Fourier-Transformation, z.B. der Algorithmen der "Fast Fourier Transformation / FFT".

Die Auswertung kann jedoch auch im Zeitbereich erfolgen, wobei dann charakteristische Änderungen der Kurvenformen der Messspannung in Vergleich zur Erregungsspannung beurteilt werden.

Des Weiteren zeichnet sich das neue Verfahren vorzugsweise dadurch aus, dass auch die Transferfunktion, d.h. die Übertragungsfunktion zwischen Erregungssignal und Messsignal, in einem erweiterten Frequenzbereich, zur sichereren Erkennung von Blechkurzschlüssen verwendet wird.

Als besonderer Vorteil ist der kleine Leistungsbedarf der Erregung bei guter Empfindlichkeit zu nennen. Insbesondere die pulsförmige Erregung erlaubt es, einerseits bei der Längsspannung grössenordnungsmässig in den Bereich der Normalbetriebsspannung / Betriebsinduktion vorzudringen.

Andererseits können kleine Handapparate ("hand held") gebaut werden, die Messungen an schwer zugänglichen Stellen erlauben.

Grundlage des neuen Verfahrens ist, wie bereits eingangs erläutert, die Erkenntnis, dass ein nicht-sinusförmiges (periodisches) Einganssignal mathematisch als eine Summe von sinusförmigen Signalkomponenten dargestellt werden kann (im Falle eines periodischen Signals als Fourier-Reihe, im Falle eines nicht-periodischen Signals als Fourier-Spektrum), und dass ein lineares System (und als ein solches reagiert das hier zu analysierende System im wesentlichen) so auf dieses Eingangssignal reagiert, dass sein Ausgangssignal wiederum in genau diese harmonischen Einzelkomponenten aufgeteilt werden kann, wobei eine definierte Transferfunktion existiert. Diese Funktion beschreibt die Phasen- und Amplitudenrelationen zwischen Eingangsharmonischen und zugehörigen Ausgangsharmonischen (bei periodischen Signalen die Anteile bei den ganzzahligen Vielfachen der Grundfrequenz), wobei sich die einzelnen Harmonischen im als linear betrachteten System nicht gegenseitig beeinflussen.

Grundlage ist des Weiteren die Erkenntnis, dass bis zu einer gewissen Grenzfrequenz der elektrische Kreis des Blechkurzschlusses im wesentlichen resistiv ist. Das bedeutet, dass der Kurzschlussstrom in diesem Kreis mit guter Näherung nur von der Erregungsspannung abhängt, jedoch nur wenig von der Erregungsfrequenz beeinflusst wird. Dieser Sachverhalt gilt auch für die Einzelharmonischen des Erregungssignals. Der Erregungsstrom selbst nimmt im Gegensatz dazu bei steigender Frequenz annähernd linear ab. Diese Zusammenhänge werden zur Identifizierung von Blechkurzschlüssen ausgenützt.

Ausserdem ist eine weitere Grundlage die Erkenntnis, dass ein Generator aufgrund seiner Blechung bis zu mittleren Frequenzen von ca. 2 kHz noch relativ verlustarm, d.h. als guter Transformator, arbeitet. Die bedeutet einerseits, dass sich der Erregungsstrom bis zu höheren Frequenzen, d.h. höheren Harmonischen, im wesentlichen linear in der Amplitude reduziert, andererseits die "Nutzspannung", das ist die vom Blechschlussstrom in der Messsonde induzierte Spannung, mit der Frequenz im wesentlichen linear steigt. Die 5. Harmonische benötigt somit z.B. nur 1/25 des Stromes der Grundharmonischen, um die gleiche Nutzspannung zu erzeugen.

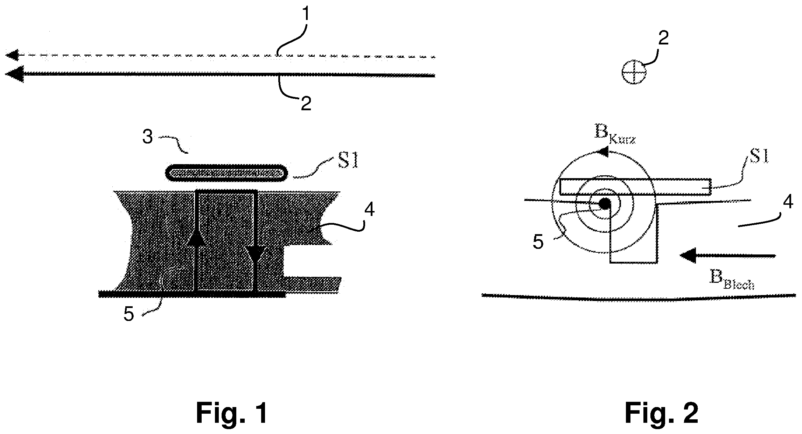

Figur 1 zeigt, um die allgemeine Messmethode zu illustrieren, die Sensorspule S1 im Querschnitt 3 und das Blechpaket 4 im Längsschnitt (längs der Rotorachse 1), die Blechebene liegt normal zur Bildebene. Die Sensorspule S1 ist oberhalb des Blechpakets 4 im Spalt der Maschine angeordnet. Im Blechpaket 4 wird infolge des angelegten periodischen Erregungsstroms 2 bei einem Blechkurzschluss ein Kurzschlussstrom 5 induziert,

Figur 2 zeigt die gleiche Anordnung, jedoch als Schnitt quer zur Rotorachse 1. anhand dieser Figur wird ersichtlich, wie der Kurzschlussstrom im Blechkurzschluss im peripheren Bereich, das heisst am Übergang zum Spalt das Magnetfeld $B_{kurz}$ induziert, und wie dieses anschliessend ein Signal in der Spule S1 induziert. Des Weiteren ist aus dieser Figur ersichtlich, wie der Erregungsstrom 2 im Blechpaket 4 das Magnetfeld $B_{Blech}$ erzeugt.

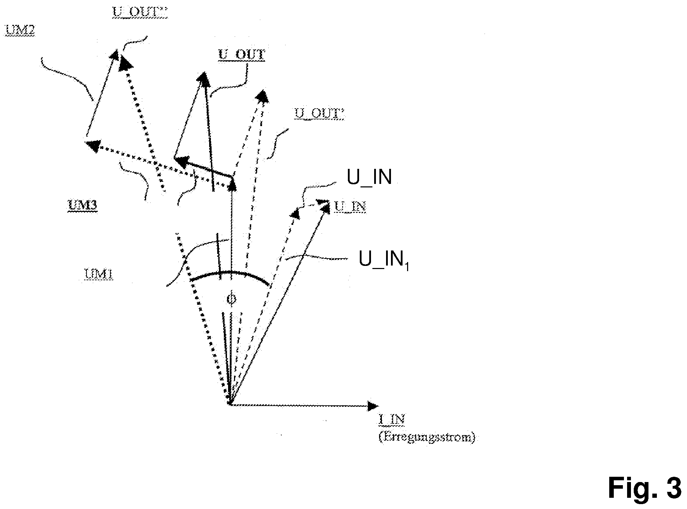

Figur 3 zeigt ein Vektordiagramm der Ströme und Spannungen. Sie zeigt die vektorielle Aufteilung der in den Sensorspulen S1 induzierten Messspannung U_OUT (Messspannung mit Blechkurzschluss). Diese Spannung U_OUT kann in 3 Hauptkomponenten aufgeteilt werden:

Eine Komponente wird direkt vom Erregungsstrom bzw. dem damit verbundenem Feld induziert (UM1), eine andere (UM2) entsteht durch das Streufeld des Stator-Hauptfeldes, die dritte Komponente (UM3) wird vom Feld des Kurzschlussstromes induziert.

Mit guter Näherung kann bezüglich der Frequenzabhängigkeit folgendes gesagt werden:

- UM1, die direkt vom Erregungsstrom induziert wird, bleibt mit steigender Frequenz im wesentlichen konstant. UM1 ist direkt proportional zum Erregungsstrom und zur Frequenz (unbelastete Messspule, d.h. Spannungsmessspule). Die Spannung steigt zwar linear mit der Frequenz, der Erregungsstrom fällt jedoch linear; somit bleibt UM1 im wesentlichen konstant. Aus Gründen der Übersichtlichkeit ist in Fig. 3 dieser Vektor als unabhängig von der Frequenz dargestellt.

- UM2 bleibt bei konstanter Erregungsspannung ebenfalls im wesentlichen konstant.

- UM3 steigt im wesentlichen linear mit der Frequenz. Der Grund dafür ist, dass der Kurzschlussstrom im Blechschlusskreis bei konstanter Erregungsspannung annähernd konstant bleibt und die Messspule annähernd unbelastet als Spannungsmessspule betrieben wird, d.h. sie die zeitliche Ableitung des Stromes bzw. des Feldflusses misst.

Die Eingangs-Erregungsspannung ist der Vollständigkeit halber als U_IN dargestellt, und setzt sich aus zwei Komponenten zusammen, namentlich U_IN1 und U_IN2.

Entsprechend ergibt sich für eine Situation ohne Blechkurzschluss eine Messspannung U_OUT', welche sich von U_OUT hinsichtlich der Amplitude, insbesondere aber hinsichtlich der Phase φ unterscheidet.

Für eine höhere Harmonische, das heisst eine höhere Frequenz, ergibt sich die Situation, welche mit der resultierenden U_OUT" dargestellt ist.

Allein schon aus dieser Vektordarstellung kann erkannt werden, dass gerade der Vergleich zwischen der Messung bei der Grundfrequenz (U_OUT) und einer höheren Frequenz (beispielsweise erste Harmonische bei der doppelten Frequenz) sowohl hinsichtlich Amplitude, als auch und insbesondere hinsichtlich Phase sehr stark vom Blechkurzschluss geprägt ist und entsprechend eine eindeutige Identifikation derselben ermöglicht.

Zusammenfassend formuliert bedeutet das nämlich, dass sich die einzelnen Harmonischen in ihrer Vektordarstellung, nach harmonischer Analyse der Ausgangsspannung, hauptsächlich in der Komponente UM3 unterscheiden werden, wenn eine auf die Eingangsharmonische bezogene Normierung der Amplituden durchgeführt wird, d.h. wenn die Beträge der einzelnen Eingangs-Vektoren einander angeglichen werden. Diese Erkenntnis erlaubt nun folgende Auswerteverfahren bzw. dafür benutzte Vorrichtungen:

- Erregung des Statorkerns mit einer nicht-sinusförmigen Eingangsspannung, z.B. einer periodischen Pulsfolge mit Netzperiode und rechteckförmigen Pulsen (oder anderen der oben angegebenen Pulsfolgen respektive Formen). Vorzugsweise werden die Pulse mit der Netzspannung synchronisiert, um Interferenzen bei der Messung zu vermeiden. Die Periode der Pulsfolge kann auch von der Netzperiode abweichen, z.B. nur ein Drittel der Netzperiode betragen. Vorteilhafterweise wird zur Erzeugung der Erregungsspannung eine mit Schaltern bestückte Leistungsstufe verwendet. Eine solche Vorrichtung ist beispielhaft in Figur 4 dargestellt, hier wird die Netzspannung 8 zunächst in einem Gleichrichter gleichgerichtet und anschliessend über steuerbare Schaltelemente 10 in Form einer Vollbrücke auf die gewünschte Form der Erregungsspannung V, die dann an der Erregungsspule 6 anliegt, geschaltet. Zusätzlich ist eine Steuerung 9 vorgesehen, welche es erlaubt, eine Synchronisation 7 auf die Netzfrequenz der Netzspannung 8 vorzunehmen. Die Leistungsstufe kann auch mit sehr hohen Schaltfrequenzen arbeiten, wobei die gewünschte Ausgangsspannung wie üblich mittels Pulsbreitenmodulation oder Pulsfrequenzmodulation erzeugt wird. Fig. 5 stellt verschiedene Pulsformen dar, wie sie bereits weiter oben diskutiert worden sind. Einerseits eine Rechteckfunktion in Figur 5 a), mit der Periode p und einer Amplitude +/-x. Die hier dargestellte Rechteckfunktion ist symmetrisch. Es sind aber auch asymmetrische Formen denkbar sowie Formen, in welchem beispielsweise die Periode nicht konstant ist sondern sukzessive zunimmt oder abnimmt (sweep), und es sind generell Formen mit Frequenzmodulation denkbar.

Eine verallgemeinerte Rechteckfunktion ist in Figur 5 b) dargestellt, hier umfasst der Verlauf neben jeweils einem positiven Abschnitt a und einen negativen Abschnitt b zusätzlich einen Null-Abschnitt c. Mischformen und Variationen sind ebenfalls möglich, sinnvollerweise immer dann, wenn wesentliche und erfindungsgemäss auswertbare Harmonische in einem derartigen Signal vorliegen.

Eine Dreiecksfunktion ist in Figur 5 c) dargestellt, diese kann auch verzerrt sein, in einem möglichen Grenzfall bis zu einer Sägezahnfunktion.

- Messung und Auswertung der Phasenwinkel der Differenz zwischen Ausgangs-Phasenwinkel und Eingangsphasenwinkel der einzelnen Harmonischen: Am Ort des Blechkurzschlusses werden die Phasenwinkel der einzelnen Harmonischen linear mit der Frequenz steigen. Beispielsweise wird der Phasenwinkel der 5. Harmonischen (z.B. 250 Hz bei einer Grundfrequenz von 50 Hz) etwa den fünffachen Wert des Phasenwinkels der Grundharmonischen aufweisen. An Orten ohne Blechschluss werden die Phasenwinkel der einzelnen Harmonischen wenig voneinander abweichen. Speziell dieser annähernd lineare Zusammenhang zwischen Phasenwinkel und Frequenz kann zur Identifikation von Blechschlüssen verwendet werden. Vorteilhafterweise wird dazu das übliche Phasendiagramm (das "Phasenspektrum") der FFT - Spektralanalyse verwendet. Vorteilhafterweise wird als Referenzspannung zur Messung und Berechnung der Phasenwinkel eine Spannung verwendet, die direkt aus der Kerninduktion abgeleitet wird, z.B. mittels einer um den Statorkern und durch die Bohrung gelegten Messschleife.

- Darstellung der Phasenwinkel der einzelnen Harmonischen als "Trends", z.B. in einem einzigen Bild, als übereinander angeordnete Linienzüge, in Abhängigkeit der axialen Position der Messspule. Dazu wird bei der Messung wie üblich die Sonde entlang der Innenoberfläche des Blechpakets in axialer Richtung bewegt.

- Darstellung der einzelnen Vektoren der Harmonischen im Polarkoordinaten - Diagramm nach Betrag und Phasenwinkel, wobei wiederum eine Vielzahl von an verschiedenen Orten aufgenommenen Messpunkten dargestellt wird. Vorteilhafterweise wird wiederum eine Amplitudennormierung durchgeführt, d.h. die Längen der einzelnen Vektoren werden durch geeignete Multiplikation einander angeglichen. Zur Auswertung können die Vektoren der Harmonischen noch durch Drehung übereinander gelegt werden.

- Eichung der Messvorrichtung mittels einer an der Bohrungsoberfläche angeordneten Leiterschleife und eines durch diese Schleife fliessenden Eichstromes bekannter Grösse, der die jeweiligen Harmonischen enthält, z.B. Verwendung eines annähernd rechteckförmigen Eichstromes. Vorteilhafterweise wird dieser Eichstrom mit dem Magnetisierungssignal synchronisiert. Bei der Eichung wird festgestellt, welche Relation zwischen Amplitude der Eich-Stromharmonischen und Grösse der Phasendifferenz in Vergleich zu einer Messung ohne Eichstrom besteht. Es wird also gemessen, welche Phasenverwerfung der Eichstrom bewirkt.

- Auswertung der Messsignale im Zeitbereich: Auch im Zeitbereich können aufgrund der differenzierenden Wirkung der Messspule in Bezug auf den Blechschlusskreis Orte mit Blechschlüssen von Orten ohne Blechschüssen unterschieden werden. Z. B. wird eine Dreiecks- oder Rampenpulsfolge (umgekehrter Sägezahn) als Erregungsspannung eine Messspannung bewirken, die der Erregungsspannung zeitmässig in den Nulldurchgängen etwas voreilt, da jetzt eine Rampenpulsfolge vorliegt, die mit einem Rechtecksignal überlagert ist usw..

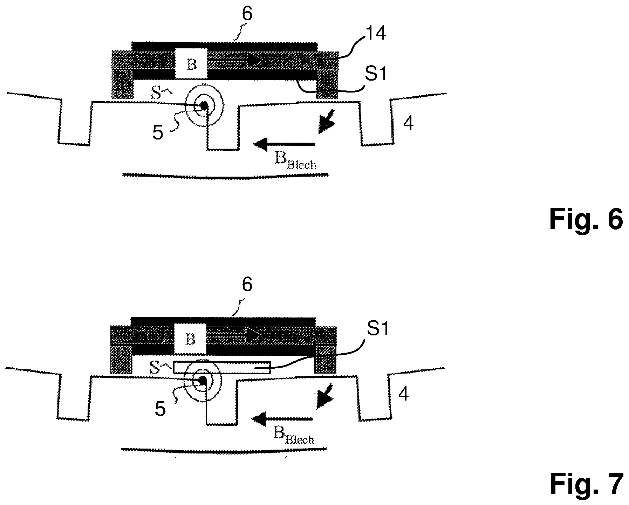

- Die Erregung kann auch nur lokal erfolgen. Dazu wird gemäss Fig. 6 beispielsweise oberhalb der (Luft)-Messspule S1 ein Eisenjoch 14 angeordnet, welches in Bügelform die Messspule S1 umfasst. Die Messspule S1 kann auch koaxial mit der Erregungsspule auf das Joch 14 gewickelt sein, oder es können Messspule und Erregungsspule 6 als eine einzige Spule ausgebildet sein. Im Fall einer einzigen Spule, die zugleich als Mess- und Erregungsspule verwendet wird, muss vorzugsweise eine kombinierte Strom-Spannungsanalyse durchgeführt werden. Kennzeichen eines Blechkurzschlusses sind in diesem Fall Zusatzverluste, die annähernd konstant bleiben bei steigender Frequenz und normierter Amplitude der Harmonischen, d.h. der Phasenwinkel zwischen Eingangsspannung und Eingangsstrom der jeweiligen Harmonischen fällt mit steigender Frequenz im Vergleich mit dem entsprechenden Phasenwinkel an fehlerlosen Orten. Die Amplitude des Erregungsstromes fällt ja mit steigender Frequenz. Zur magnetisch leitenden Verbindung auf den Stator -Eisenkörper können magnetisch leitende Rollen, z.B. aus in Kunststoff eingebettetem Ferrit-Material, verwendet werden.

Eine getrennte Anordnung von einem breiteren Erregungsjoch 14 mit Erregungsspule 6 und einer schmalen Messspule S1 gemäss Fig. 7 hat den Vorteil, dass mit einer relativ schmalen Messspule die Fehler besser lokalisiert werden können.

**Bezugszeichenliste**

| 1 | Richtung Rotorachse |
|---|---|
| 2 | Erregungsstrom |
| 3 | Querschnitt durch Sensorspule |
| 4 | Blechpaket im Stator |
| 5 | Kurzschlussstrom |
| 6 | Erregungsspule |
| 7 | Synchronisation |
| 8 | Netzspannung |
| 9 | Steuerung |
| 10 | Halbleiter-Schaltelemente |
| 11 | Gleichrichter |
| 12 | Wechselrichter |
| 13 | Erregungsspule und Sensor |
| 14 | Erregungsjoch |

| S1 | Sensorspule |
|---|---|
| $B_{kurz}$ | durch peripheren Verlauf von 5 induziertes Magnetfeld |
| $B_{Blech}$ | im Blechpaket induziertes Magnetfeld |
| $\varphi$ | Phasenwinkel |
| UM1 | vom Erregungsstrom induzierte Komponente |
| UM2 | durch das Streufeld des Stator-Hauptfeldes induzierte Komponente |
| UM3 | durch das Feld des Kurzschlussstromes Bkurz induzierte Komponente |
| U_OUT | in den Sensorspulen induzierte Messspannung |
| U_OUT' | U_OUT für den Fall ohne Blechfehler |
| U_OUT" | U_OUT für eine Situation bei höherer Frequenz |
| U_IN | Eingangs-Erregungsspannung |
| I_IN | Erregungsstrom, auch mit Bezugszeichen 2 bezeichnet |
| $U\_IN_1$ | Komponente von U_IN, Spannung Induktion Eisenkern (Kernverluste: Wirbelstrom, Ummagnetisierung usw.) |
| $U\_IN_2$ | Komponente von U_IN, Spannungsanteil ohmsche Kabelverluste und Streufeld |
| V | an Erregungsspule anliegende Erregungsspannung |
| p | Periode von V |
| a | positiver Abschnitt von V |
| b | negativer Abschnitt von V |

c        neutraler Abschnitt von V

**Patentansprüche**

1. Verfahren zur Detektion von interlaminaren Blechschlüssen im Stator-Blechpaket (4) von Elektromaschinen, bei welchem das Stator-Blechpaket (4) einem von aussen angelegten Erregungsstrom (2) respektive Erregungsspannung (V) ausgesetzt wird und unter Zuhilfenahme einer im Spalt der Maschine angeordneten und diesen Spalt abtastende Sensorspule (S1) das durch Kurzschlussströme (5) induzierte Kurzschluss-Magnetfeld (Bkurz) ausgemessen wird, **dadurch gekennzeichnet, dass** Erregungsstrom (2) respektive Erregungsspannung (V) einen wesentlich von einer Sinusform abweichenden zeitlichen Verlauf aufweisen, und dass der zeitliche Verlauf von Erregungsstrom (2) respektive Erregungsspannung (V) ein periodischer Verlauf mit wesentlichen höheren Harmonischen ist, deren höhere harmonische Komponenten mit zunehmender Frequenz eine abnehmende Amplitude aufweisen.

2. Verfahren nach Anspruch 1, **dadurch gekennzeichnet, dass** der Erregungsstrom so gewählt wird, dass zumindest kurzfristig die Betriebslängsspannung erreicht wird.

3. Verfahren nach einem der vorangehenden Ansprüche, **dadurch gekennzeichnet, dass** es sich beim zeitlichen Verlauf von Erregungsstrom (2) respektive Erregungsspannung (V) um eine Sägezahnfunktion, eine Rechteckfunktion oder eine modifizierte Rechteckfunktion handelt.

4. Verfahren nach einem der vorangehenden Ansprüche, **dadurch gekennzeichnet, dass** es sich beim zeitlichen Verlauf von Erregungsstrom (2) respektive Erregungsspannung (V) um eine symmetrische Rechteckfunktion mit gleich langen positiven (a) und negativen (b) Abschnitten handelt.

5. Verfahren nach einem der vorangehenden Ansprüche, **dadurch gekennzeichnet, dass** der zeitliche Verlauf von Erregungsstrom (2) respektive Erregungsspannung (V) eine Grund-Frequenz im Bereich von 10-500 Hz, insbesondere bevorzugt im Bereich von 40-100 Hz aufweist.

6. Verfahren nach Anspruch 5, **dadurch gekennzeichnet, dass** die Grund-Frequenz mit der für die Erregung verwendeten Netzspannung synchronisiert ist.

7. Verfahren nach einem der vorangehenden Ansprüche, **dadurch gekennzeichnet, dass** Messung und Auswertung auf Basis der Phasenwinkel (phi), definiert als Differenz zwischen Ausgangs-Phasenwinkel und Eingangs-Phasenwinkel der einzelnen Harmonischen von Erregungsstrom (2) respektive Erregungsspannung (V), erfolgt.

8. Verfahren nach Anspruch 7, **dadurch gekennzeichnet, dass** der im wesentlichen lineare Zusammenhang zwischen Phasenwinkel und Frequenz zur Identifikation von Blechschlüssen verwendet wird.

9. Verfahren nach einem der vorangehenden Ansprüche, **dadurch gekennzeichnet, dass** zur Identifikation von Blechschlüssen das in der Sensorspule aufgenommene Signal einer spektralen Analyse unter Zuhilfenahme einer Fourier Transformation unterzogen wird, wobei insbesondere bevorzugt das Phasenspektrum der unterschiedlichen Harmonischen zur Identifikation von Blechschlüssen verwendet wird.

10. Verfahren nach einem der vorangehenden Ansprüche, **dadurch gekennzeichnet, dass** eine Eichung der Messvorrichtung mittels einer an der Bohrungsoberfläche angeordneten Leiterschleife und eines durch diese Schleife fliessenden Eichstromes bekannter Grösse, der im wesentlichen die gleichen Harmonischen enthält, wie der zeitliche Verlauf von Erregungsstrom (2) respektive Erregungsspannung (V) während der eigentlichen Messung, wobei insbesondere bevorzugt zu Eichung der gleiche zeitliche Verlauf wie zur Messung verwendet wird.

11. Verfahren nach einem der vorangehenden Ansprüche, **dadurch gekennzeichnet, dass** zur Identifikation von Blechschlüssen eine kombinierte Strom-Spannungsanalyse durchgeführt wird, bevorzugt unter Berücksichtigung des insbesondere fallenden Phasenwinkels in Abhängigkeit steigender Frequenz.

12. Verfahren nach Anspruch 1, **dadurch gekennzeichnet, dass** jeweils für eine Messung an einem bestimmten Ort im wesentlichen ein einziger Puls, insbesondere bevorzugt ein Rechteckpuls als Verlauf von Erregungsstrom (2) respektive Erregungsspannung (V) angelegt wird respektive eine Folge von unabhängig voneinander ausgewerteten und im Resultat gemittelten Pulsen.

**13.** Verfahren nach einem der vorangehenden Ansprüche, **dadurch gekennzeichnet, dass** Messung und Auswertung auf Blechschlüsse auf Basis der Phasenlage und Amplitude in der einzelnen Harmonischen verwendet wird.

**14.** Verfahren nach einem der vorangehenden Ansprüche, **dadurch gekennzeichnet, dass** Phasenlagen und Amplitude der Harmonischen mittels Fourier-Analyse analysiert werden.

**15.** Verfahren nach einem der vorangehenden Ansprüche, **dadurch gekennzeichnet, dass** eine örtlich simultane Änderung der Phasenwinkel mehrerer Harmonischer als Hinweis auf einen BlechKurzschluss gewertet werden.

**16.** Verfahren nach einem der vorangehenden Ansprüche, **dadurch gekennzeichnet, dass** ein im wesentlichen linearer Zusammenhang zwischen Änderungen der Phasenwinkel und Frequenz der Harmonischen als Hinweis auf einen Blechschluss gewertet wird.

**17.** Vorrichtung zur Durchführung eines Verfahrens nach einem der vorangehenden Ansprüche, **dadurch gekennzeichnet, dass** eine Sensorspule angeordnet ist, sowie eine Erregungsvorrichtung zur Erzeugung einer Erregungsspannung respektive eines Erregungsstroms im Blechpaket (4), wobei zusätzlich ein Frequenz-Generator zur Ansteuerung der Erregungsvorrichtung vorgesehen ist, welcher dazu ausgelegt ist, die Erregungsvorrichtung mit einem Erregungsstrom (2) respektive einer Erregungsspannung (V) mit einem wesentlich von einer Sinusform abweichenden zeitlichen Verlauf anzusteuern, und dass der zeitliche Verlauf von Erregungsstrom (2) respektive Erregungsspannung (V) ein periodischer Verlauf mit wesentlichen höheren Harmonischen ist, deren höhere harmonische Komponenten mit zunehmender Frequenz eine abnehmende Amplitude aufweisen.

**18.** Vorrichtung nach Anspruch 17, **dadurch gekennzeichnet, dass** es sich beim Frequenz-Generator eine elektronische Vollbrücke ist.

**19.** Vorrichtung nach einem der Ansprüche 17 oder 18, **dadurch gekennzeichnet, dass** zur Erregung eine Erregungsspule (6), in Kombination mit einem Erregungsjoch (14), verwendbar ist.

**Claims**

**1.** Method for detection of interlaminar laminate shorts in the laminated stator core (4) of electrical machines, in which the laminated stator core (4) is subjected to an externally applied field current (2) or field voltage (V), and the short-circuit magnetic field ($B_{short}$) induced by short-circuit currents (5) is measured with the assistance of a sensor coil (S1) which is arranged in the gap in the machine and probes this gap, **characterized in that** the field current (2) and field voltage (V) have a waveform which differs significantly from a sinusoidal shape, and **in that** the waveform of the field current (2) or field voltage (V) is a periodic waveform with significant higher harmonics, the higher harmonic components of which have a decreasing amplitude as frequency rises.

**2.** Method according to Claim 1, **characterized in that** the field current is chosen such that the operating direct-axis voltage is reached at least briefly.

**3.** Method according to one of the preceding claims, **characterized in that** the waveform of the field current (2) or field voltage (V) is a sawtooth function, a square-wave function or a modified square-wave function.

**4.** Method according to one of the preceding claims, **characterized in that** the waveform of the field current (2) or field voltage (V) is a symmetrical square-wave function with positive (a) and negative (b) sections of the same length.

**5.** Method according to one of the preceding claims, **characterized in that** the waveform of the field current (2) or field voltage (V) has a fundamental frequency in the range 10-500 Hz, in particular preferably in the range 40-100 Hz.

**6.** Method according to Claim 5, **characterized in that** the fundamental frequency is synchronized to the mains voltage used for the field.

**7.** Method according to one of the preceding claims, **characterized in that** measurement and evaluation are carried out on the basis of the phase angle (phi), defined as the difference between the output phase angle and the input phase angle of the individual harmonics of the field current (2) or field voltage (V) .

8. Method according to Claim 7, **characterized in that** the substantially linear relationship between the phase angle and frequency is used for identification of laminate shorts.

9. Method according to one of the preceding claims, **characterized in that** the signal recorded in the sensor coil is subjected to spectral analysis with the assistance of a Fourier transformation for identification of laminate shorts, wherein, in particular and preferably, the phase spectrum of the various harmonics is used for identification of laminate shorts.

10. Method according to one of the preceding claims, **characterized in that** the measurement apparatus is calibrated by means of a conductor loop, which is arranged on the bore surface, and a calibration current, which flows through this loop of a known magnitude and contains substantially the same harmonics as the waveform of the field current (2) or field voltage (V) during the actual measurement, wherein, in particular and preferably, the same waveform is used for calibration as for measurement.

11. Method according to one of the preceding claims, **characterized in that** a combined current/voltage analysis is carried out for identification of laminate shorts, preferably taking account of the, in particular, falling, phase angle as a function of rising frequency.

12. Method according to Claim 1, **characterized in that** substantially a single pulse, in particular and preferably a square-wave pulse, is applied as the waveform of the field current (2) or field voltage (V) or a sequence of pulses which are evaluated independently of one another and are averaged overall, is in each case used for a measurement at a specific point.

13. Method according to one of the preceding claims, **characterized in that** measurement and evaluation of laminate shorts is used on the basis of the phase angles and amplitudes in the individual harmonics.

14. Method according to one of the preceding claims, **characterized in that** the phase angles and amplitudes of the harmonics are analyzed by means of Fourier analysis.

15. Method according to one of the preceding claims, **characterized in that** a spatially simultaneous change in the phase angles of a plurality of harmonics is assessed as an indication of a laminate short circuit.

16. Method according to one of the preceding claims, **characterized in that** a substantially linear relationship between changes in the phase angle and frequency of the harmonics is assessed as an indication of a laminate short.

17. Apparatus for carrying out a method according to one of the preceding claims, **characterized in that** a sensor coil is arranged, as well as a field apparatus for production of a field voltage or a field current in the laminated core (4), wherein a frequency generator is additionally provided in order to operate the field apparatus, and is designed to operate the field apparatus with a field current (2) or a field voltage (V) with a waveform which differs substantially from a sinusoidal shape, and **in that** the waveform of the field current (2) or field voltage (V) is a periodic waveform with significant higher harmonics, the higher harmonic components of which have a decreasing amplitude as frequency rises.

18. Apparatus according to Claim 17, **characterized in that** the frequency generator is an electronic full bridge.

19. Apparatus according to one of Claims 17 or 18, **characterized in that** a field coil (6) can be used, in combination with a field yoke (14), for energizing.

**Revendications**

1. Procédé de détection de contacts entre tôles interlaminaires dans l'empilage de tôles de stator (4) de machines électriques, avec lequel l'empilage de tôles de stator (4) est exposé à un courant d'excitation (2) ou une tension d'excitation (V) appliqué(e) depuis l'extérieur et le champ magnétique de court-circuit (Bkurz) induit par des courants de court-circuit (5) est mesuré à l'aide d'une bobine de détection (S1) disposée dans l'entrefer de la machine et balayant cet entrefer, **caractérisé en ce que** le courant d'excitation (2) ou la tension d'excitation (V) possède un tracé dans le temps sensiblement différent d'une forme sinusoïdale, et **en ce que** le tracé dans le temps du courant d'excitation (2) ou de la tension d'excitation (V) est un tracé périodique avec des harmoniques sensiblement plus élevées dont les composantes harmoniques plus élevées possèdent une amplitude qui diminue à mesure que la fréquence augmente.

2. Procédé selon la revendication 1, **caractérisé en ce que** le courant d'excitation est choisi de telle sorte que la tension longitudinale de fonctionnement est atteinte au moins pendant une courte durée.

3. Procédé selon l'une des revendications précédentes, **caractérisé en ce que** le tracé dans le temps du courant d'excitation (2) ou de la tension d'excitation (V) est une fonction en dents de scie, une fonction rectangulaire ou une fonction rectangulaire modifiée.

4. Procédé selon l'une des revendications précédentes, **caractérisé en ce que** le tracé dans le temps du courant d'excitation (2) ou de la tension d'excitation (V) est une fonction rectangulaire symétrique ayant des portions positives (a) et négatives (b) de longueur identique.

5. Procédé selon l'une des revendications précédentes, **caractérisé en ce que** le tracé dans le temps du courant d'excitation (2) ou de la tension d'excitation (V) possède une fréquence fondamentale dans la plage de 10 à 500 Hz, notamment de préférence dans la plage de 40 à 100 Hz.

6. Procédé selon la revendication 5, **caractérisé en ce que** la fréquence fondamentale est synchronisée avec la tension de réseau utilisée pour l'excitation.

7. Procédé selon l'une des revendications précédentes, **caractérisé en ce que** la mesure et l'interprétation est effectuée sur la base de l'angle de phase (phi), défini comme étant la différence entre l'angle de phase de sortie et l'angle de phase d'entrée des harmoniques individuelles du courant d'excitation (2) ou de la tension d'excitation (V).

8. Procédé selon la revendication 7, **caractérisé en ce que** la relation sensiblement linéaire entre l'angle de phase et la fréquence est utilisée pour l'identification des contacts entre tôles.

9. Procédé selon l'une des revendications précédentes, **caractérisé en ce que** pour l'identification des contacts entre tôles, le signal enregistré dans la bobine de détection est soumis à une analyse spectrale à l'aide d'une transformation de Fourier, le spectre de phase des différentes harmoniques étant notamment de préférence utilisé pour l'identification des contacts entre tôles.

10. Procédé selon l'une des revendications précédentes, **caractérisé en ce qu'**un étalonnage du dispositif de mesure est effectué pendant la mesure proprement dite au moyen d'une boucle conductrice disposée sur la surface de l'alésage et d'un courant d'étalonnage de grandeur connue qui circule à travers cette boucle, lequel contient sensiblement les mêmes harmoniques que le tracé dans le temps du courant d'excitation (2) ou de la tension d'excitation (V), le même tracé dans le temps que pour la mesure étant notamment de préférence utilisé pour l'étalonnage.

11. Procédé selon l'une des revendications précédentes, **caractérisé en ce que** pour l'identification des contacts entre tôles, une analyse combinée du courant et de la tension est effectuée, de préférence en tenant compte de l'angle de phase notamment chutant en fonction de la fréquence croissante.

12. Procédé selon la revendication 1, **caractérisé en ce que** pour la mesure respective à un endroit défini, une impulsion unique est sensiblement appliquée, notamment de préférence une impulsion rectangulaire en tant que tracé du courant d'excitation (2) ou de la tension d'excitation (V), ou une séquence d'impulsions interprétées indépendamment les unes des autres et dont la moyenne est calculée pour obtenir le résultat.

13. Procédé selon l'une des revendications précédentes, **caractérisé en ce que** la mesure et l'interprétation de la présence de contacts entre tôles est utilisée sur la base des positions de phases et des amplitudes dans les harmoniques individuelles.

14. Procédé selon l'une des revendications précédentes, **caractérisé en ce que** les positions de phases et les amplitudes des harmoniques sont analysées au moyen d'une analyse de Fourier.

15. Procédé selon l'une des revendications précédentes, **caractérisé en ce qu'**une modification locale simultanée de l'angle de phase de plusieurs harmoniques est considérée comme une indication d'un court-circuit entre tôles.

**16.** Procédé selon l'une des revendications précédentes, **caractérisé en ce qu'**une relation sensiblement linéaire entre les modifications de l'angle de phase et de la fréquence des harmoniques est considérée comme une indication d'un contact entre tôles.

**17.** Dispositif pour mettre en oeuvre un procédé selon l'une des revendications précédentes, **caractérisé en ce qu'**une bobine de détection est disposée ainsi qu'un dispositif d'excitation destiné à générer une tension d'excitation ou un courant d'excitation dans l'empilage de tôles de stator (4), un générateur de fréquence étant en plus présent pour commander le dispositif d'excitation, lequel est conçu pour commander le dispositif d'excitation avec un courant d'excitation (2) ou une tension d'excitation (V) ayant un tracé dans le temps sensiblement différent d'une forme sinusoïdale, et **en ce que** le tracé dans le temps du courant d'excitation (2) ou de la tension d'excitation (V) est un tracé périodique avec des harmoniques sensiblement plus élevées dont les composantes harmoniques plus élevées possèdent une amplitude qui diminue à mesure que la fréquence augmente.

**18.** Dispositif selon la revendication 17, **caractérisé en ce que** le générateur de fréquence est un pont complet électronique.

**19.** Dispositif selon l'une des revendications 17 ou 18, **caractérisé en ce qu'**une bobine d'excitation (6) en combinaison avec une culasse d'excitation (14) peut être utilisée pour l'excitation.

**Fig. 1**

**Fig. 2**

**Fig. 3**

Fig. 4

Fig. 5

**Fig. 6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4996486 A
- WO 0210737 A2

- US 6903556 B